# EUROPÄISCHE PATENTSCHRIFT

(11) **EP 3 005 565 B1**
(45) Veröffentlichungstag und Bekanntmachung des Hinweises auf die Patenterteilung: **31.10.2018**
(21) Anmeldenummer: 14725697.8
(22) Anmeldetag: 22.05.2014
(51) Int. Cl.: H03K 17/945, H03K 17/94, G06F 3/01, G06F 3/03

(54) **SCHALTERBETÄTIGUNGSEINRICHTUNG, MOBILES GERÄT UND VERFAHREN ZUM BETÄTIGEN EINES SCHALTERS DURCH EINE NICHT-TAKTILE "PUSH"-GESTE**
SWITCH ACTUATION SYSTEM, MOBILE DEVICE AND METHOD FOR ACTUATING A SWITCH USING A NON-TACTILE PUSH GESTURE
DISPOSITIF D'ACTIONNEMENT DE COMMUTATEUR, APPAREIL MOBILE ET PROCÉDÉ POUR ACTIONNER UN COMMUTATEUR PAR UN GESTE DE POUSSÉE NON TACTILE

(30) Priorität: 24.05.2013 US 201361827108 P
(43) Veröffentlichungstag der Anmeldung: 13.04.2016
(73) Patentinhaber: Pyreos Ltd., Edinburgh EH9 3JF (GB)
(72) Erfinder: GIEBELER, Carsten, Edinburgh EH32 OPE (GB); BROWN, Spyros, Edinburgh EH11 2LJ (GB); CHAMBERLAIN, Tim, Edinburgh EH5 2ad (GB); HURWITZ, Jonathan Ephraim David, Edinburgh EH6 7PJ (GB)
(74) Vertreter: Leach, James
(86) Internationale Anmeldenummer: PCT/EP2014/060549
(87) Internationale Veröffentlichungsnummer: WO 2014/187902

(56) Entgegenhaltungen:
- JP-A- 2008 232 715
- US-A1- 2008 266 083
- US-A1- 2010 204 953
- US-A1- 2010 295 773
- US-A1- 2011 050 643
- HENG-TZE CHENG ET AL: "Contactless gesture recognition system using proximity sensors", CONSUMER ELECTRONICS (ICCE), 2011 IEEE INTERNATIONAL CONFERENCE ON, IEEE, 9. Januar 2011 (2011-01-09), Seiten 149-150, XP031921157, DOI: 10.1109/ICCE.2011.5722510 ISBN: 978-1-4244-8711-0
- WOJTCZUK P ET AL: "Recognition of Simple Gestures Using a PIR Sensor Array", SENSORS & TRANSDUCERS, INTERNATIONAL FREQUENCY SENSOR ASSOCIATION, CA, Bd. 14, Nr. 1, 12. März 2012 (2012-03-12), Seiten 83-94, XP002714652, ISSN: 1726-5479
- YONG SIN KIM ET AL: "A motion gesture sensor using photodiodes with limited field-of-view", OPTICS EXPRESS, Bd. 21, Nr. 8, 22. April 2013 (2013-04-22) , Seite 9206, XP055090605, ISSN: 1094-4087, DOI: 10.1364/OE.21.009206

## Beschreibung

Schalterbetätigungseinrichtung, mobiles Gerät und Verfahren zum Betätigen eines Schalters durch eine nicht-taktile "Push"-Geste Die Erfindung betrifft eine Schalterbetätigungseinrichtung, ein mobiles Gerät mit der Schalterbetätigungseinrichtung und ein Verfahren zur Betätigung eines Schalters mit der Schalterbetätigungseinrichtung durch eine nicht-taktile "Push"-Geste, insbesondere einer menschlichen Hand.

Zur Mensch-Computer-Interaktion sind interaktive Systeme und deren Mensch-Maschine-Schnittstellen bekannt, die mit einer Einrichtung zur automatischen Erkennung von durch Menschen ausgeführten nicht-taktilen oder taktilen Gesten ausgestattet sind. Die Geste kann prinzipiell von jeder Körperhaltung und jeder Körperbewegung abgeleitet werden, wobei die größte Bedeutung Handgesten haben. Die Gestenerkennungseinrichtung ist mit einem Gerät zur optischen Erfassung insbesondere der gestikulierenden Hand ausgestattet, wobei die dadurch erzeugten Bildinformationen mit entsprechenden Algorithmen ausgewertet werden, um eine Geste aus den Bildinformationen abzuleiten. Das Gerät zur optischen Erfassung einer nicht-taktilen Geste ist herkömmlich eine Kamera, die nachteilig einen großen Bauraum einnimmt und hohe Investitionskosten hat. Dadurch sind kamerabasierte Einrichtungen zur Gestenerkennung in miniaturisierter Bauweise bei günstigen Kosten, wie es etwa für die Anwendung von Mobiltelefonen vorteilhaft wäre, nicht zu realisieren. Außerdem haben kamerabasierte Einrichtungen nachteilig einen hohen Energieverbrauch, wodurch mobile Anwendungen nur schwer umzusetzen sind. Alternativ sind Hochgeschwindigkeitsspektrometer bekannt, die hinsichtlich der miniaturisierten Bauweise bei großen Kosten keine Abhilfe schaffen können. Außerdem sind Berührungsbildschirme für insbesondere Mobiltelefone bekannt, jedoch sind die Berührungsbildschirme für die Erkennung von taktilen Gesten und nicht für die Erkennung von nicht-taktilen Gesten geeignet.

Weiter ist aus WOJTCZUK P ET AL: "Recognition of Simple Gestures Using a PIR Sensor Array",SENSORS & TRANSDUCERS, INTERNATIONAL FREQUENCY SENSOR ASSOCIATION, CA, Bd. 14, Nr. 1, 12. März 2012, Seiten 83-94, bekannt, eine Matrix aus pyroelektrischen Dünnschichtsensoren aus Bleizirkonattitanat zur Erkennung von einfachen Gesten zu verwenden.

Aufgabe der Erfindung ist es eine Schalterbetätigungseinrichtung, ein mobiles Gerät mit der Schalterbetätigungseinrichtung und ein Verfahren zur Betätigung eines Schalters mit der Schalterbetätigungseinrichtung durch eine nicht-taktile "Push"-Geste zu schaffen, wobei die Schalterbetätigungseinrichtung eine miniaturisierte Bauweise bei günstigen Kosten und geringem Energieverbrauch hat und die Betätigung des Schalters mit der Schalterbetätigungseinrichtung sicher und fehlerarm ist.

Die Aufgabe wird gelöst mit den Merkmalen der Patentansprüche 1, 6 und 12. Bevorzugte Ausgestaltungen sind in den weiteren Patentansprüchen angegeben.

Die erfindungsgemäße Schalterbetätigungseinrichtung weist einen Gestensensor zum Betätigen eines Schalters durch eine nicht-taktile "Push"-Geste, die mit einem wärmeemittierenden Teil auzuüben ist und von einer Annäherungsphase, bei der das Teil sich dem Gestensensor annähert, einer Wartephase, bei der das Teil in der Nähe des Gestensensors verharrt und einer Rückzugsphase, bei der das Teil vom Gestensensor weg zu bewegen ist, gebildet ist, wobei der Gestensensor eingerichtet ist beim Ausüben der Geste vom Teil emittierte Wärme mittels mindestens einem einen Dünnfilm aus pyroelektrischem Material aufweisenden Pixel zu detektieren und pro Pixel ein Signal mit Signalausschlägen entsprechend dem zeitlichen Intensitätsverlauf der vom Pixel detektierten Wärme auszugeben, eine Signalauswerteeinheit, mit der aus dem zeitlichen Aufeinanderfolgen der Signalausschläge die Ausübung der Geste ermittelt ist, und einen Aktuator auf, der von der Signalauswerteeinheit angesteuert und, sobald die Ausübung der Geste ermittelt ist, den Schaler betätigt. Das pyroelektrische Material ist insbesondere Bleizirkonattitanat.

Das erfindungsgemäße mobile Gerät weist die Schalterbetätigungseinrichtung auf, wobei der Schalter zum Aktivieren/Deaktivieren einer Funktionalität des mobilen Geräts in diesem verschaltet ist.

Das erfindungsgemäße Verfahren zum Betreiben der Schalterbetätigungseinrichtung weist die Schritte auf: Ausüben der nicht-taktilen "Push"-Geste mit dem wärmeemittierenden Teil, so dass von dem Pixel der Signalausschlag hervorgerufen in der Annäherungsphase und der Signalausschlag hervorgerufen in der Rückzugsphase an die Signalauswerteeinheit ausgegeben werden, wobei zwischen den Signalausschlägen während der Wartephase vom Signal ein Warteniveau erreicht wird, das einen geringeren Absolutwert hat als das Niveau der Signalausschläge; Überwachen des Signals und Identifizieren des Auftretens einer Aufeinanderfolge der Signalausschläge und dem zeitlich dazwischenliegenden Warteniveau des Signals; sobald die Aufeinanderfolge identifiziert wurde: Ansteuern des Aktuators zum Betätigen des Schalters durch die Signalauswerteeinheit.

Das alternative erfindungsgemäße Verfahren zum Betreiben der Schalterbetätigungseinrichtung weist die Schritte auf: Ausüben von zwei unmittelbar zeitlich aufeinanderfolgenden nicht-taktilen "Push"-Gesten, bei denen jeweils die Wartephase Null Sekunden andauert, mit dem wärmeemittierenden Teil, so dass von dem Pixel eine Aufeinanderfolge von Signalausschlägen in Form des Signalausschlags hervorgerufen in der Annäherungsphase der ersten "Push"-Geste, des Signalausschlags hervorgerufen in der Rückzugsphase der ersten "Push"-Geste, des Signalausschlags hervorgerufen in der Annäherungsphase der zweiten "Push"-Geste und des Signalausschlags hervorgerufen in der Rückzugsphase der zweiten "Push"-Geste an die Signalauswerteeinheit ausgegeben wird, wobei die Signalausschläge hervorgerufen in den Annäherungsphasen eine andere Richtung haben als die Signalausschläge hervorgerufen in den Rückzugsphasen; Überwachen des Signals und Identifizieren des Auftretens der Aufeinanderfolge von den Signalausschlägen; sobald die Aufeinanderfolge identifiziert wurde: Ansteuern des Aktuators zum Betätigen des Schalters durch die Signalauswerteeinheit.

Dadurch, dass das Pixel den Dünnfilm aus dem pyroelektrischen Material, bevorzugt Bleizirkonattitanat, aufweist, ist das Signal, das vom wärmeemittierenden Teil beim Ausüben der "Push"-Geste erzeugt wird, derart vorteilhaft beschaffen, dass die Erkennung der "Push"-Geste mit den erfindungsgemäßen Verfahren sicher und fehlerarm durchführbar ist. Außerdem ist der Gestensensor mit dem Pixel derart in einer miniaturisierten Bauweise bei günstigen Kosten herstellbar, dass die Schalterbetätigungseinrichtung für das mobile Gerät vorteilhaft einsetzbar ist. Das Signal wird mit dem Dünnfilm durch die von dem Teil emittierte Wärme erzeugt, so dass der Gestensensor mit einer externen Energiequelle nicht mit Energie versorgt zu werden braucht. Damit weist die Schalterbetätigungseinrichtung die Signalwerteeinheit und den Aktuator als Energieverbraucher auf, so dass insgesamt der Energieverbrauch der Schalterbetätigungseinrichtung für das mobile Gerät vorteilhaft niedrig ist.

Bevorzugtermaßen weist der Gestensensor mindestens zwei der Pixel auf. Dadurch sind der Signalauswerteeinheit zwei unabhängig voneinander erzeugte Signale bereitgestellt, wobei die Auswertung der Signale und die damit einhergehende Gestenerkennung vorteilhaft redundant ausgeführt ist.

Das Teil ist bevorzugt eine menschliche Hand und die vom Teil emittierte Wärme ist bevorzugt die von der menschlichen Hand abgestrahlte Körperwärme. Mit den erfindungsgemäßen und/oder bevorzugten Ausgestaltungen der Schalterbetätigungseinrichtung ist die Erkennung der nicht-taktilen "Push"-Geste mit der menschlichen Hand im Rahmen üblicher menschlicher Bewegungsabläufe besonders sicher und fehlerarm ermöglicht.

Bevorzugtermaßen weist das erste alternative erfindungsgemäße Verfahren den Schritt auf: Überprüfen, ob der Zeitversatz der Signalausschläge innerhalb einer ersten vorherbestimmten Zeitspanne liegt; ist die Überprüfung positiv, Fortfahren mit dem nächsten Schritt. Hierbei ist es bevorzugt, dass die erste vorherbestimmte Zeitspanne zwischen 300 ms und 2000 ms liegt. Des Weiteren weist bevorzugtermaßen das erste alternative erfindungsgemäße Verfahren den Schritt auf: Überprüfen, ob die Signalausschläge verschiedene Richtungen haben; ist die Überprüfung positiv, Fortfahren mit dem nächsten Schritt. Es ist ferner bevorzugt, dass für die Signalausschläge der Amplitudenverlauf des von dem Pixel ausgegebenen Signals verwendet wird. Hierbei ist es bevorzugt, dass überprüft wird, ob der Absolutwert des Warteniveaus höchstens bei 20 % des Absolutwerts des Signalniveaus liegt, das bei einem Nichtansprechen des Pixels vorherrscht. Alternativ ist es bevorzugt, dass für die Signalausschläge die erste Ableitung nach der Zeit des Amplitudenverlaufs des vom Pixel ausgegebenen Signals verwendet wird. Hierzu ist es bevorzugt, dass überprüft wird, ob das Warteniveau höchstens bei 20 % mindestens eines der Absolutwerte des Signalniveaus der Signalausschläge liegt. Bevorzugt ist es außerdem, dass überprüft wird, ob das Warteniveau im Wesentlichen bei Null liegt.

Für das zweite alternative erfindungsgemäße Verfahren ist bevorzugt, dass zwischen den Signalausschlägen der Aufeinanderfolge jeweils eine Zeitspanne liegt, die innerhalb eines vorherbestimmten Zeitbereichs liegt. Hierbei ist es bevorzugt, dass der vorherbestimmte Zeitbereich von 100 ms bis 1500 ms beträgt. Ferner weist bevorzugtermaßen das zweite alternative erfindungsgemäße Verfahren den Schritt auf: Überprüfen, ob die Absolutwerte der Signalausschläge über einem vorherbestimmten Niveau liegen; ist die Überprüfung positiv, Fortfahren mit dem nächsten Schritt. Ferner ist es bevorzugt, dass der Gestensensor mindestens zwei der Pixel aufweist und bevorzugtermaßen überprüft wird, ob die analogen, zueinander gehörenden Signalausschläge jeweils innerhalb einer zweiten vorherbestimmten Zeitspanne liegen; ist die Überprüfung positiv, Fortfahren mit dem nächsten Schritt. Hierbei ist es bevorzugt, dass die zweite vorherbestimmte Zeitspanne 50 ms beträgt.

Indem der Absolutwert des Wartniveaus höchstens bei 20 % des Absolutwerts des Signalniveaus bevorzugt liegen soll, wird vorteilhaft erreicht, dass Störsignale, die etwa durch Einflüsse aus der Umgebung des Gestensensors abgegeben werden, die Gestenauswertung nicht oder zumindest kaum beeinträchtigen, wodurch die Genauigkeit der Gestenerkennung erhöht ist.

Durch die erfindungsgemäße und/oder bevorzugte Definition der Abläufe der Signalausschläge, die der "Push"-Geste zugeordnet sind, ist die Treffsicherheit beim Erkennen der "Push"-Geste aus beliebigen Gesten vorteilhaft hoch, wodurch eine sichere und fehlerfreie Gestenerkennung ermöglich ist. Entsprechen beispielsweise die Abläufe der Signalausschläge einer ausgeübten Geste nicht den Signalausschlägen der "Push"-Geste, so wird diese Geste als keine "Push"-Geste interpretiert. In überraschender Weise wird durch das Heranziehen der vom Dünnfilm aus dem pyroelektrischen Material, bevorzugt Bleizirkonattitanat, erzeugten Signalausschläge für die Identifizierung der "Push"-Geste eine übermäßige Steigerung der Präzision der Gestenerkennung erzielt.

Im Folgenden wird eine bevorzugte Ausführungsform der Erfindung anhand der beigefügten schematischen Zeichnungen erläutert. Es zeigen:
Figur 1 eine schematische Darstellung einer erfindungsgemäßen Schalterbetätigungseinrichtung für ein erfindungsgemäßes mobiles Gerät,
Figur 2 ein Diagramm mit Amplitudenverläufen von Signalen eines Gestensensors aus Figur 1,
Figur 3 ein Diagramm mit der ersten Ableitung nach der Zeit der Amplitudeneerläufe aus Figur 2,
Figur 4 eine Detailansicht von Figur 2 und
Figur 5 ein Diagramm mit einer Vorschrift zur Bildung der ersten Ableitung nach der Zeit der Amplitudenverläufe, wie sie in Figur 2 gezeigt sind.

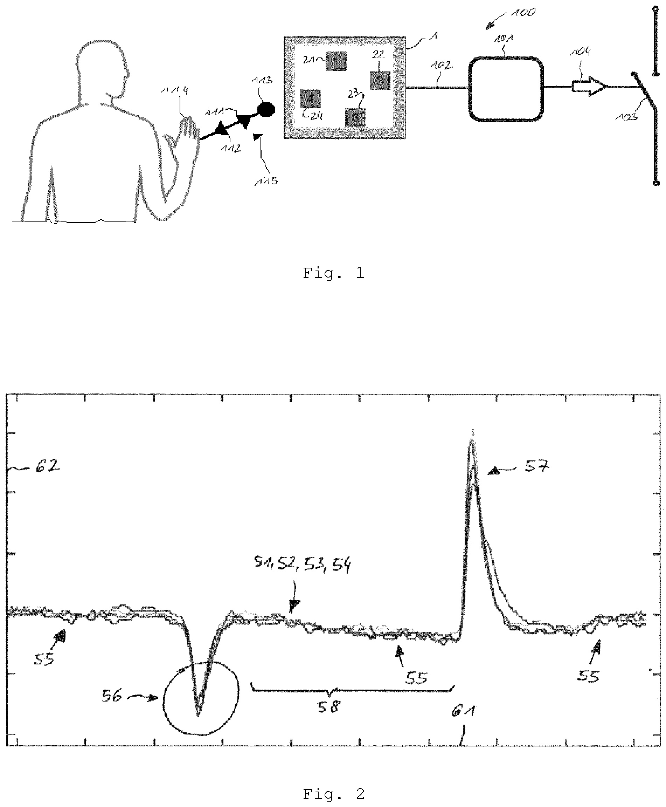

In Figur 1 ist eine Schalterbetätigungseinrichtung 100 gezeigt, die in ein mobiles Gerät eingebaut ist. Die Schalterbetätigungseinrichtung 100 weist einen Gestensensor 1 und eine Signalauswerteeinheit 101 auf, die via eine Signalleitung 102 zum Übertragen von Signalen vom Gestensensor 1 zur Signalauswerteeinheit 101 gekoppelt ist. Entsprechend der Auswertung der Signale, die vom Gestensensor 1 auf die Signalauswerteeinheit 101 übertragen werden, aktiviert oder deaktiviert die Signalauswerteeinheit 101 einen Aktuator 104, mit dem ein Schalter 103 des mobilen Geräts betätigbar ist. Der Schalter 103 ist zum Aktivieren/Deaktivieren einer Funktionalität des mobilen Geräts in diesem verschaltet.

Der Gestensensor 1 ist zum Detektieren von "Push"-Gesten vorgesehen, wobei, je nachdem, ob eine "Push"-Geste 115 detektiert wurde, ein Signal oder mehrere Signale via die Signalleitung 102 zur Signalauswerteeinheit 101 übertragen werden, aufgrund dessen die Betätigung des Schalters 103 via den Aktuator 104 bewerkstelligt ist. Die Betätigung des Schalters 103 wird nur dann ausgelöst, wenn vom Gestensensor 1 und von der Signalauswerteeinheit 101 die "Push"-Geste 115 identifiziert ist.

Die Gesten sind mit einer Hand 114 in der Nähe des Gestensensors 1 nicht-taktil auszuüben, wobei vom Gestensensor 1 von der Hand 114 emittierte Wärme detektierbar ist. Die "Push"-Geste 115 setzt sich aus dem zeitlichen unmittelbaren Ablauf einer Annäherungsphase 111, einer Wartephase 113 und einer Rückzugsphase 112 zusammen. Beim Ausführen der "Push"-Geste 115 wird die Hand 114 dem Gestensensor 101 während der Annäherungsphase 111 angenähert und, nach Ablauf der Wartephase 113, während der die Hand 114 benachbart zum Gestensensor 1 verharrt, während der Rückzugsphase 112 wieder vom Gestensensor 1 entfernt.

Als Alternative oder zusätzlich ist es vorgesehen, dass der Schalter 103 mit zwei zeitlich hintereinander ausgeführten "Push"-Gesten betätigt wird, die jeweils lediglich aus der Annäherungsphase 111 und der Rückzugsphase 112 bestehen, wobei die Wartephase 113 jeweils Null Sekunden beträgt. Das heißt, bei diesen beiden "Push"-Gesten mit der Wartephase 113 gleich Null Sekunden wird die Hand 114 dem Gestensensor 1 angenähert, wegbewegt, wieder angenähert und sodann wieder wegbewegt, ohne dass die Hand 114 in der Nähe des Gestensensors 1 eine wesentliche Zeitdauer verharrt. Die Signalauswerteeinheit 101 ist derart eingerichtet, dass sie die "Push"-Geste mit der Wartephase 113, die mehr als Null Sekunden andauert, und/oder zwei unmittelbar aufeinanderfolgenden "Push"-Gesten zu identifizieren, deren Wartephasen 113 jeweils bei Null Sekunden liegen.

Der Gestensensor 1 weist ein erstes Pixel 21, ein zweites Pixel 22, ein drittes Pixel 23 und ein viertes Pixel 24 auf. Die Pixel 21 bis 24 weisen jeweils einen Dünnfilm aus Bleizirkonattitanat auf, mit dem jeweils das Signal erzeugt wird, sobald von dem jeweiligen Pixel 21 bis 24 von der Hand 114 emittierte Wärme detektiert wird. Somit wird beim Ausüben der "Push"-Geste 115 mit der Hand 114 von jedem Pixel 21 bis 24 das Signal mit einem Signalausschlag entsprechend dem zeitlichen Intensitätsverlauf der vom Dünnfilm des entsprechenden Pixels 21 bis 24 an die Signalauswerteeinheit 101 ausgegebenen. Das Signal des ersten Pixels 21 ist mit dem Bezugszeichen 51, das Signal des zweiten Pixels 22 ist mit dem Bezugszeichen 52, das Signal des dritten Pixels 23 ist mit dem Bezugszeichen 53 und das Signal des vierten Pixels 24 ist mit dem Bezugszeichen 54 bezeichnet.

In Figur 2 ist ein Diagramm mit den zeitlichen Amplitudenverläufen der von den Pixeln 21 bis 24 ausgegebenen Signalen gezeigt, wobei über der Abszisse 61 die Zeit und über die Ordinate 62 die Amplitude aufgetragen sind. Die Signale 51 bis 54 weisen jeweils Signalausschläge 56, 57 auf, wobei die Signalausschläge 56 bei der Annäherung der Hand 114 an den Gestensensor 1 und die Signalausschläge 71 beim Rückzug der Hand 114 vom Gestensensor 1 erzeugt werden. Zwischen den Signalausschlägen 56, 57 ist eine Wartedauer 58 angesiedelt, die die Wartephase 113 bildet, wohingegen die Signalausschläge 56 die Annäherungsphase 111 und die Signalausschläge 57 die Rückzugsphase 112 bilden. Während der Wartephase 113 stellt sich ein Signalniveau 55 bei Pixelpassivität ein, die eintritt, wenn keine von der Hand 114 emittierte Wärme von dem Gestensensor 1 detektiert wird. Das Signalniveau 55 stellt sich ebenfalls in Vorlauf des Signalausschlags 56 bei Annäherung und im Nachgang zum Signalausschlag 57 bei Rückzug der Hand 114 ein.

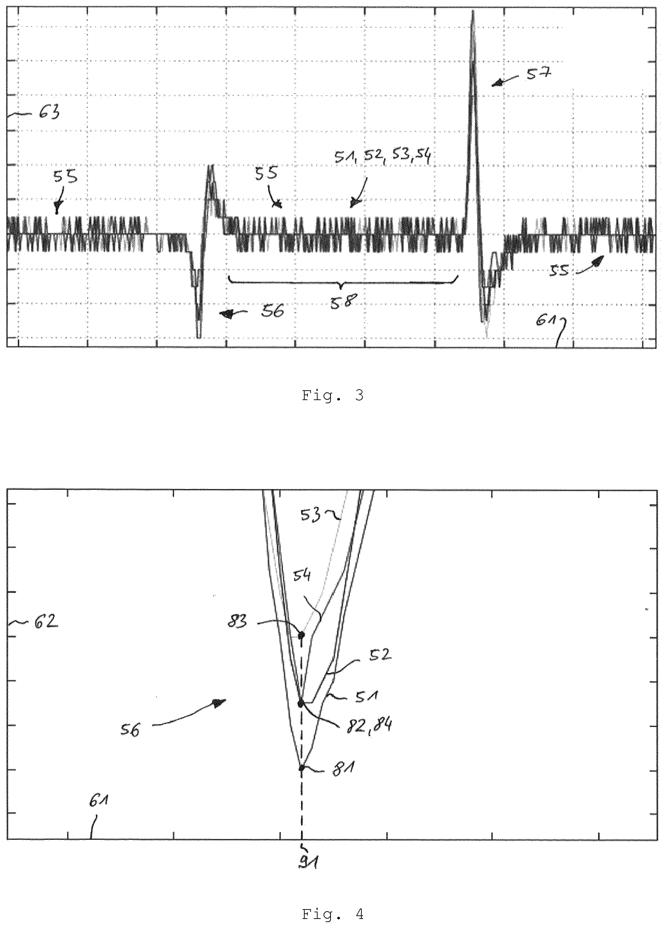

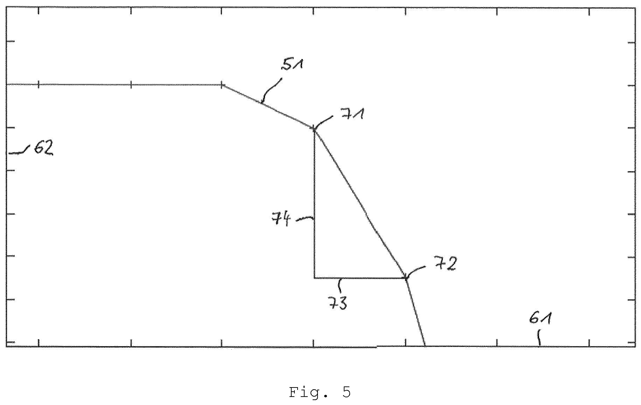

Alternativ zu Figur 2 ist in Figur 3 über die Ordinate 63 die erste Ableitung nach der Zeit der in Figur 2 aufgetragenen Amplitudenverläufe dargestellt. In Figur 5 ist ein repräsentativer Ausschnitt eines der Signale 51 bis 54 gezeigt, wobei die Amplitude dieses Signal über die Zeit aufgetragen ist. Der Amplitudenverlauf ist insbesondere von einem ersten Stützpunkt 71, einem zweiten Stützpunkt 72 gebildet, wobei die Stützpunkte 71 und 72 durch ein Zeitinkrement 73 zueinander zeitlich versetzt sind und zwischen den Stützpunkten 71 und 72 eine Amplitudendifferenz 74 ausgebildet ist. Die zeitliche Ableitung nach der Zeit ist diskret mit einem Quotienten aus der Amplitudendifferenz 74 und dem Zeitinkrement 73 zu bilden.

In Figur 4 ist ein Detail aus Figur 2 gezeigt, wobei der Signalausschlag 56 bei Annäherung der Hand 114 an den Gestensensor 1 vergrößert dargestellt ist. Es sind die Verläufe der Amplituden der Signale 51 bis 54 gezeigt, wobei jeder der Amplitudenverläufe ein Minimum 81 bis 84 aufweist. Die Signale 51 bis 54 sind durch die "Push"-Geste 115 gemäß der ersten Alternative erzeugt. Beim Ausüben der "Push"-Geste 115 werden gleichzeitig die vier Pixel 21 bis 24 angesprochen. Dadurch ist der qualitative Verlauf der Signale 51 bis 54 zeitgleich, so dass die Minima 81 bis 84 gleichzeitig im Zeitpunkt 91 auftreten. Die "Push"-Geste 115 wird so ausgeführt, dass die Hand 114 während der Annäherungsphase 111 zum Gestensensor 1 hin bewegt wird, während der Wartephase 113 in der Nähe des Gestensensors 1 die Wartedauer 58 verharrt und anschließend während der Rückzugsphase 112 wieder vom Gestensensor 1 wegbewegt wird. Die Bewegung der Hand während der Annäherungsphase 111 und der Rückzugsphase 112 soll im Wesentlichen senkrecht zur von den Pixeln 21 bis 24 aufgespannten Ebene sein. Während dem Ausüben der "Push"-Geste 115 detektieren die Pixel 21 bis 24 die von der Hand 114 emittierte Wärme simultan, so dass die Signale 51 bis 54 von den Pixeln 21 bis 24 generiert werden.

Bei der Betätigung der Schalterbetätigungseinrichtung 100 können von der Hand 114 beliebige Gesten ausgeübt werden. Jedoch ist es so vorgesehen, dass nur beim Ausüben der "Push"-Geste 115 der Schalter 103 betätigt werden soll. Somit gilt es aus einer Vielzahl an möglichen Gesten und Störungseinflüssen aus der Umgebung der Schalterbetätigungseinrichtung 100 das Vorhandensein der "Push"-Geste 115 zu identifizieren.

Zur Identifikation der ausgeübten Geste werden die Signale 51 bis 54 von dem Gestensensor 1 an die Signalauswerteeinheit 101 übertragen. In der Signalauswerteeinheit 101 wird geprüft, ob die Signale 51 bis 54 die Signalausschläge 56 und 57 aufweisen, wobei zwischen den Signalausschlägen 56 und 57 während der Wartephase 113 das Warteniveau 55 vorliegen soll. Es wird ferner in der Signalauswerteeinheit 101 überprüft, ob der Zeitversatz der Signalausschläge 56 und 57 innerhalb einer ersten vorherbestimmten Zeitspanne liegt, die zwischen 300 ms und 2000 ms gewählt werden kann. Außerdem wird in der Signalauswerteeinheit 101 überprüft, ob die Signalausschläge 56 und 57 verschiedene Richtungen haben. Das heißt, es wird überprüft, ob der Signalausschlag 56 ein geringeres Niveau als das Warteniveau 55 und der Signalausschlag 57 ein höheres Niveau als das Warteniveau 55 hat bzw. ob der Signalausschlag 56 ein höheres Niveau als das Warteniveau 55 und der Signalausschlag 57 ein geringeres Niveau als das Warteniveau 55 hat. Zusätzlich wird in der Signalauswerteeinheit 101 überprüft, ob der Absolutwert des Warteniveaus 55 höchstens bei 20 % des Absolutwerts des Signalniveaus liegt, das bei einem Nichtansprechen des Pixels vorherrscht. In Figur 2 ist das Signalniveau bei einem Nichtansprechen des Pixels 21 bis 24 mit dem Signalniveau 25 bei Pixelpassivität gleichgesetzt.

Ergeben die Überprüfungen in der Signalauswerteeinheit 101, dass die vorher genannten Kriterien erfüllt sind, wird die vom Gestensensor detektierte Geste als die "Push"-Geste 115 identifiziert. Dementsprechend, wie es in der Signalauswerteeinheit 101 hinterlegt ist, wird via den Aktuator 104 der Schalter 103 betätigt. Gesten, die nicht als die "Push"-Geste 115 identifiziert werden, werden in der Signalauswerteeinheit 101 verworfen. Grundsätzlich ist jede beliebige Kombination an den Überprüfungen in jeder beliebigen Reihenfolge denkbar.

Alternativ ist die Signalauswerteeinheit 101 derart konfiguriert, dass zwei unmittelbar zeitlich aufeinanderfolgende "Push"-Gesten die Betätigung des Schalters 103 durch den Aktuator 104 auslösen. Die beiden unmittelbar zeitlich aufeinanderfolgenden "Push"-Gesten haben jeweils eine Wartephase 113, die Null Sekunden andauert. Dadurch ergibt sich eine Aufeinanderfolge von Signalausschlägen in Form des Signalausschlags 56 hervorgerufen in der Annäherungsphase 111 der ersten "Push"-Geste, des Signalausschlags 57 hervorgerufen in der Rückzugsphase 112 der ersten "Push"-Geste, eines Signalausschlags hervorgerufen in der Annäherungsphase der zweiten "Push"-Geste und eines Signalausschlags hervorgerufen in der Rückzugsphase der zweiten "Push"-Geste. Die Signalausschläge hervorgerufen in den Annäherungsphasen haben eine andere Richtung als die Signalausschläge hervorgerufen in den Rückzugsphasen. Der Schalter 103 wird dann von der Signalauswerteeinheit 101 via den Aktuator 104 betätigt, wenn zwischen den einzelnen Signalausschlägen der Aufeinanderfolge jeweils eine Zeitspanne von 100 ms bis 1500 ms liegt und ob die zueinander gehörenden Signalausschläge jeweils innerhalb einer Zeitspanne von 50 ms liegen. Grundsätzlich ist jede beliebige Kombination an den Überprüfungen in jeder beliebigen Reihenfolge denkbar.

### Bezugszeichenliste

- 1: Gestensensor
- 21: erstes Pixel
- 22: zweites Pixel
- 23: drittes Pixel
- 24: viertes Pixel
- 51: Signal des ersten Pixels
- 52: Signal des zweiten Pixels
- 53: Signal des dritten Pixels
- 54: Signal des vierten Pixels
- 55: Signalniveau bei Pixelpassivität
- 56: Signalausschlag bei Annäherung
- 57: Signalausschlag bei Rückzug
- 58: Wartedauer
- 61: Abszisse: Zeit
- 62: Ordinate: Amplitude
- 63: Ordinate: erste Ableitung der Amplitude
- 71: erster Stützpunkt
- 72: zweiter Stützpunkt
- 73: Zeitinkrement
- 74: Amplitudendifferenz
- 81: erstes Minimum
- 82: zweites Minimum
- 83: drittes Minimum
- 84: viertes Minimum
- 91: Zeitpunkt
- 100: Schalterbetätigungseinrichtung
- 101: Signalauswerteeinheit
- 102: Signalleitung
- 103: Schalter
- 104: Aktuator
- 111: Annäherungsphase
- 112: Rückzugsphase
- 113: Wartephase
- 114: Hand
- 115: "Push"-Geste

## Patentansprüche

1. Schalterbetätigungseinrichtung (100) mit einem Aktuator, der zum Betätigen eines Schalters (103) eingerichtet ist, mit einem Gestensensor (1) der zur Detektion einer nicht-taktile "Push"-Geste (115) eingerichtet ist, die mit einem Wärme emittierenden Teil (114) auszuüben ist und von einer Annäherungsphase (111), bei der das Teil (114) sich dem Gestensensor (1) annähert, einer Wartephase (113), bei der das Teil (114) in der Nähe des Gestensensors (1) verharrt, und einer Rückzugsphase (112), bei der das Teil (114) vom Gestensensor (1) wegzubewegen ist, gebildet ist, wobei der Gestensensor (1) eingerichtet ist beim Ausüben der Geste (115) vom Teil (114) emittierte Wärme mittels mindestens einem einen Dünnfilm aus pyroelektrischem Material aufweisenden Pixel (21 bis 24) zu detektieren und pro Pixel (21 bis 24) ein Signal (51 bis 54) mit Signalausschlägen (56, 57) entsprechend dem zeitlichen Intensitätsverlauf der vom Pixel (21 bis 24) detektierten Wärme auszugeben, mit einer Signalauswerteeinheit (101), die dazu eingerichtet ist, aus dem zeitlichen Aufeinanderfolgen der Signalausschläge (56, 57) die Ausübung der Geste (115) zu ermitteln und sobald die Ausübung der Geste (115) ermittelt ist, den Aktuator (104) anzusteuern, welcher eingerichtet ist daraufhin den Schalter (103) zu betätigen.

2. Schalterbetätigungseinrichtung gemäß Anspruch 1, wobei das pyroelektrische Material Bleizirkonattitanat ist.

3. Schalterbetätigungseinrichtung gemäß Anspruch 1 oder 2, wobei der Gestensensor (1) mindestens zwei der Pixel (21 bis 24) aufweist.

4. Schalterbetätigungseinrichtung gemäß Anspruch 1 bis 3, wobei das Teil eine menschliche Hand (114) und die vom Teil emittierte Wärme die von der menschlichen Hand (114) abgestrahlte Körperwärme ist.

5. Mobiles Gerät mit der Schalterbetätigungseinrichtung (100) gemäß einem der Ansprüche 1 bis 4, wobei der Schalter (103) zum Aktivieren / Deaktivieren einer Funktionalität des mobilen Geräts in diesem verschaltet ist.

6. Verfahren zum Betreiben einer Schalterbetätigungseinrichtung (100) gemäß einem der Ansprüche 1 bis 4, mit den Schritten:
- Ausgeben von dem Pixel (21 bis 24) den Signalausschlag (56) hervorgerufen in der Annäherungsphase (111) und den Signalausschlag (57) hervorgerufen in der Rückzugsphase (112) an die Signalauswerteeinheit (101), indem die nicht-taktile "Push"-Geste (115) mit dem Wärme emittierenden Teil (114) ausgeübt wird, wobei zwischen den Signalausschlägen (56, 57) während der Wartephase (113) vom Signal ein Warteniveau (55) erreicht wird, das einen geringeren Absolutwert hat als das Niveau der Signalausschläge (56, 57);
- Überwachen des Signals (51 bis 54) und identifizieren des Auftretens einer Aufeinanderfolge der Signalausschläge (56, 57) und dem zeitlich dazwischen liegenden Warteniveau (55) des Signals (51 bis 54);
- Sobald die Aufeinanderfolge identifiziert wurde: Ansteuern des Aktuators (104) zum Betätigen des Schalters (103) durch die Signalauswerteeinheit (101).

7. Verfahren gemäß Anspruch 6, mit dem Schritt:
- Überprüfen, ob der Zeitversatz der Signalausschläge (56, 57) innerhalb einer ersten vorherbestimmten Zeitspanne liegt, die insbesondere zwischen 300 ms und 2000 ms liegt; Ist die Überprüfung positiv, Fortfahren mit dem nächsten Schritt.

8. Verfahren gemäß einem der Ansprüche 6 bis 7, mit dem Schritt:
- Überprüfen, ob die Signalausschläge (56, 57) verschiedene Richtungen haben; Ist die Überprüfung positiv, Fortfahren mit dem nächsten Schritt.

9. Verfahren gemäß einem der Ansprüche 6 bis 8, wobei für die Signalausschläge (56, 57) der Amplitudenverlauf des von dem Pixel (21 bis 24) ausgegeben Signals (51 bis 54) verwendet wird, wobei das Verfahren insbesondere den Schritt aufweist:
- Überprüfen, ob der Absolutwert des Warteniveaus (55) höchstens bei 20% des Absolutwerts des Signalniveaus liegt, das bei einem Nichtansprechen des Pixels (21 bis 24) vorherrscht.

10. Verfahren gemäß einem der Ansprüche 6 bis 8, wobei für die Signalausschläge (56, 57) die erste Ableitung nach der Zeit des Amplitudenverlaufs des von dem Pixel (21 bis 24) ausgegeben Signals (51 bis 54) verwendet wird.

11. Verfahren gemäß Anspruch 10, mit dem Schritt:
- Überprüfen, ob das Warteniveau (55) höchstens bei 20% mindestens eines der Absolutwerte der Signalniveaus der Signalausschläge (56, 57) liegt;
- Überprüfen, ob das Warteniveau (55) im Wesentlichen bei Null liegt.

12. Verfahren zum Betreiben einer Schalterbetätigungseinrichtung (100) gemäß einem der Ansprüche 1 bis 4, mit den Schritten:
- Ausgeben von dem Pixel (21 bis 24) eine Aufeinanderfolge von Signalausschlägen in Form des Signalausschlags (56) hervorgerufen in der Annäherungsphase (111) einer ersten "Push"-Geste, des Signalausschlags (57) hervorgerufen in der Rückzugsphase (112) der ersten "Push"-Geste, des Signalausschlags hervorgerufen in der Annäherungsphase einer zweiten "Push"-Geste und des Signalausschlags hervorgerufen in der Rückzugsphase der zweiten "Push"-Geste an die Signalauswerteeinheit (101), indem zwei unmittelbar zeitlich aufeinanderfolgende nicht-taktile "Push"-Gesten, bei denen jeweils die Wartephase (113) Null Sekunden andauert, mit dem Wärme emittierenden Teil (114) ausgeübt werden, wobei die Signalausschläge hervorgerufen in den Annäherungsphasen eine andere Richtung haben als die Signalausschläge hervorgerufen in den Rückzugsphasen;
- Überwachen des Signals (51 bis 54) und identifizieren des Auftretens der Aufeinanderfolge von den Signalausschlägen;
- Sobald die Aufeinanderfolge identifiziert wurde: Ansteuern des Aktuators (104) zum Betätigen des Schalters (103) durch die Signalauswerteeinheit (101).

13. Verfahren gemäß Anspruch 12, wobei zwischen den Signalausschlägen der Aufeinaderfolge jeweils eine Zeitspanne liegt, die innerhalb eines vorherbestimmten Zeitbereichs liegt, wobei der vorherbestimmte Zeitbereich insbesondere von 100 ms bis 1500 ms beträgt.

14. Verfahren gemäß einem der Ansprüche 6 bis 13, mit dem Schritt:
- Überprüfen, ob die Absolutwerte der Signalausschläge (56, 57) über einem vorherbestimmten Niveau liegen; Ist die Überprüfung positiv, Fortfahren mit dem nächsten Schritt.

15. Verfahren gemäß einem der Ansprüche 6 bis 14, wobei der Gestensensor (1) mindestens zwei der Pixel (21 bis 24) aufweist, mit dem Schritt:
- Überprüfen, ob die analogen, zueinander gehörenden Signalausschläge jeweils innerhalb einer zweiten vorherbestimmten Zeitspanne liegen, die insbesondere 50 ms beträgt; Ist die Überprüfung positiv, Fortfahren mit dem nächsten Schritt.

## Claims

1. Switch operating device (100) with an actuator that is adapted for operating a switch (103), wherein the switch operating device (100) comprises a gesture sensor (1) that is adapted for detecting a non-tactile push-gesture (115) that is to be performed with a part (114) emitting heat, wherein the gesture (115) is formed by an approach phase (111), during which the part (114) approaches the gesture sensor (1), followed by a waiting phase (113), during which the part (114) remains in proximity of the gesture sensor (1), followed by a withdrawal phase (112), during which the part (114) is moved away from the gesture sensor (1), wherein the gesture sensor (1) is adapted to detect heat emitted by the part (114) by means of at least one pixel (21 to 24) that comprises a thin film out of pyroelectric material and to output per pixel (21 to 24) a signal (51 to 54) with signal deflections (56, 57) corresponding to the temporal intensity curve of the heat detected by the pixel (21 to 24) in response to the performance of the gesture (115), wherein the switch operating device (100) comprises a signal processing unit (101) that is adapted to determine the performance of the gesture (115) out of the temporal succession of the signal deflections (56, 57) and to control the actuator (104) as soon as the performance of the gesture (115) is determined, wherein the actuator (104) is adapted to operate the switch (103) as soon as the performance of the gesture (115) is determined.

2. Switch operating device according to claim 1, wherein the pyroelectric material is lead-zirconate-titanate.

3. Switch operating device according to claim 1 or 2, wherein the gesture sensor (1) comprises at least two of the pixels (21 to 24).

4. Switch operating device according to claim 1 to 3, wherein the part is a human hand (114) and the heat emitted from the part is the body heat radiated by the human hand (114).

5. Mobile device with the switch operating device (100) according to any one of the claims 1 to 4, wherein the switch (103) is interconnected in the mobile device for activating / deactivating a functionality of the mobile device.

6. Method for operating a switch operating device (100) according to any one of the claims 1 to 4, wherein the method comprises the steps:
- outputting the signal deflection (56) generated in the approach phase (111) and the signal deflection (57) generated in the withdrawal phase (112) from the pixel (21 to 24) to the signal processing unit (101) in response to the performance of the non-tactile push-gesture (115) with the part (114) emitting heat, wherein a waiting level (55) that has a lower absolute value than the level of the signal deflections (56, 57) is reached by the signal between the signal deflection (56, 57) during the waiting phase (113);
- monitoring the signal (51 to 54) and identifying the occurrence of a succession of the signal deflections (56, 57) and the waiting level (55) of the signal (51 to 54), wherein the waiting level (55) is temporal between the signal deflections (56, 57);
- as soon as the succession is identified: controlling the actuator (104) to operate the switch (103) via the signal processing unit (101).

7. Method according to claim 6, wherein the method comprises the step:
- verifying if the temporal delay of the signal deflections (56, 57) is within a first predetermined time span, that is in particular between 300 ms and 2000 ms; If the verification is positive, proceeding with the next step.

8. Method according to any one of the claims 6 to 7, wherein the method comprises the step:
- verifying if the signal deflections (56, 57) have different directions; If the verification is positive, proceeding with the next step.

9. Method according to any one of the claims 6 to 8, wherein the amplitude curve of the signal (51 to 54) that is outputted by the pixel (21 to 24) is used for the signal deflections (56, 57), wherein the method comprises in particular the step:
- verifying if the absolute value of the waiting level (55) is at most at 20% of the absolute value of the signal level that prevails during a non-responding of the pixel (21 to 24).

10. Method according to any one of the claims 6 to 8, wherein the first derivative with respect to time of the amplitude curve of the signal (51 to 54) that is outputted by the pixel (21 to 24) is used for the signal deflections (56, 57).

11. Method according to claim 10, wherein the method comprises the step:
- verifying if the waiting level (55) is at most 20% of at least one of the absolute values of the signal levels of the signal deflections (56, 57);
- verifying if the waiting level (55) is substantially at zero.

12. Method for operating a switch operating device (100) according to any one of the claims 1 to 4, wherein the method comprises the steps:
- outputting a succession of signal deflections in shape of the signal deflection (56) generated in the approach phase (111) of a first push-gesture, of the signal deflection (57) generated in the withdrawal phase (112) of the first push-gesture, the signal deflection generated in the approach phase of a second push-gesture and of the signal deflection generated in the withdrawal phase of the second push-gesture from the pixel (21 to 24) to the signal processing unit (101) in response to performance of two immediate temporal consecutive non-tactile push-gestures with the heat emitting part (114), wherein the waiting phase (113) of the two gestures lasts respectively zero seconds, wherein the signal deflections generated in the approach phases have another direction than the signal deflections generated in the withdrawal phases;
- monitoring the signal (51 to 54) and identifying the occurrence of the succession from the signal deflections;
- as soon as the succession is identified: controlling the actuator (104) for operating the switch (103) via the signal processing unit (101).

13. Method according to claim 12, wherein a time span is respectively between the signal deflections of the succession, wherein the time span is within a predetermined time range, wherein the predetermined time range is in particular from 100 ms till 1500 ms.

14. Method according to any one of the claims 6 to 13, wherein the method comprises the step:
- verifying if the absolute values of the signal deflections (56, 57) are above a predetermined level; If the verification is positive, proceeding with the next step.

15. Method according to any one of the claims 6 to 14, wherein the gesture sensor (1) comprises at least two of the pixels (21 to 24), wherein the method comprises the step:
- verifying if the mutually associated analogue signal deflections are respectively within a second predetermined timespan that is in particular 50 ms; If the verification is positive, proceeding with the next step.

## Revendications

1. Dispositif d'actionnement de commutateur (100) comportant un actionneur adapté pour actionner un commutateur (103), comportant un capteur de geste (1) adapté pour détecter un geste de "poussée" non tactile (115) qui doit être effectué avec une partie (114) émettant de la chaleur et qui est formé d'une phase d'approche (111) pendant laquelle la partie (114) se rapproche du capteur de geste (1), d'une phase d'attente (113) pendant laquelle la partie (114) reste à proximité du capteur de geste (1), et d'une phase de recul (112) pendant laquelle la partie (114) doit être éloignée du capteur de geste (1), le capteur de geste (1) étant adapté pour détecter, au moyen d'au moins un pixel (21 à 24) comportant un film mince en matériau pyroélectrique, de la chaleur émise par la partie (114) lorsque le geste (115) est effectué, et pour générer, pour chaque pixel (21 à 24), un signal (51 à 54) avec des déviations de signaux (56, 57) correspondant à la variation d'intensité dans le temps de la chaleur détectée par le pixel (21 à 24), comportant une unité d'analyse de signaux (101) adaptée pour déterminer, à partir de la séquence temporelle des déviations de signaux (56, 57), que le geste (115) est effectué et pour commander, dès que le geste (115) est effectué, l'actionneur (104) qui est adapté pour actionner le commutateur (103).

2. Dispositif d'actionnement de commutateur selon la revendication 1, dans lequel le matériau pyroélectrique est le zirconate-titanate de plomb.

3. Dispositif d'actionnement de commutateur selon la revendication 1 ou la revendication 2, dans lequel le capteur de geste (1) comporte au moins deux des pixels (21 à 24).

4. Dispositif d'actionnement de commutateur selon les revendications 1 à 3, dans lequel la partie est une main humaine (114) et la chaleur émise par la partie est la chaleur corporelle émise par la main humaine (114).

5. Appareil mobile muni du dispositif d'actionnement de commutateur (100) selon l'une des revendications 1 à 4, dans lequel le commutateur (103) est connecté dans l'appareil mobile pour activer/désactiver une fonctionnalité de ce dernier.

6. Appareil pour faire fonctionner un dispositif d'actionnement de commutateur (100) selon l'une des revendications 1 à 4, comportant les étapes consistant à :
- générer, à partir du pixel (21 à 24), la déviation de signal (56) due à la phase d'approche (111) et la déviation de signal (57) due à la phase de recul (112) sur l'unité d'analyse de signaux (101), en effectuant le geste de "poussée" non tactile (115) avec la partie (114) émettant de la chaleur, un niveau d'attente (55) étant atteint entre les déviations de signaux (56, 57) pendant la phase d'attente (113) du signal, lequel niveau d'attente a une valeur absolue inférieure au niveau des déviations de signaux (56, 57),
- surveiller le signal (51 à 54) et identifier l'occurrence d'une séquence de déviations de signaux (56, 57) et du niveau d'attente (55) du signal (51 à 54) situé temporellement entre celles-ci,
- dès que la séquence a été identifiée: commander l'actionneur (104) de manière à actionner le commutateur (103) par le biais de l'unité d'analyse de signaux (101).

7. Procédé selon la revendication 6, comportant l'étape consistant à :
- vérifier que le décalage temporel des déviations de signaux (56, 57) se situe dans un premier intervalle de temps prédéfini qui est en particulier compris entre 300 ms et 2 000 ms, si le contrôle est positif, passer à l'étape suivante.

8. Procédé selon l'une des revendications 6 à 7, comportant l'étape consistant à :
- vérifier que les déviations de signaux (56, 57) ont différentes directions, si le contrôle est positif, passer à l'étape suivante.

9. Procédé selon l'une des revendications 6 à 8, dans lequel pour les déviations de signaux (56, 57), la variation d'amplitude du signal (51 à 54) généré par le pixel (21 à 24) est utilisée, le procédé comportant en particulier l'étape consistant à :
- vérifier que la valeur absolue du niveau d'attente (55) se situe au plus à 20 % de la valeur absolue du niveau de signal qui prédomine lors d'une non-réponse du pixel (21 à 24).

10. Procédé selon l'une des revendications 6 à 8, dans lequel pour les déviations de signaux (56, 57), la première dérivation après la durée de la variation d'amplitude du signal (51 à 54) généré par le pixel (21 à 24) est utilisée.

11. Procédé selon la revendication 10, comportant les étapes consistant à :
- vérifier que le niveau d'attente (55) est au plus égal à 20 % au moins de l'une des valeurs absolues du niveau de signal des déviations de signaux (56, 57),
- vérifier que le niveau d'attente (55) est sensiblement égal à zéro.

12. Procédé pour faire fonctionner un dispositif d'actionnement de commutateur (100) selon l'une des revendications 1 à 4, comportant les étapes consistant à :
- générer, à partir du pixel (21 à 24), une séquence de déviations de signaux ayant la forme de la déviation de signal (56) due à la phase d'approche (111) d'un premier geste de "poussée", de la déviation de signal (57) due à la phase de recul (112) du premier geste de "poussée", de la déviation de signal due à la phase d'approche d'un deuxième geste de "poussée", et de la déviation de signal due à la phase de recul du deuxième geste de "poussée" sur l'unité d'analyse de signaux (101), en effectuant avec la partie (114) émettant de la chaleur deux gestes de "poussée" non tactiles immédiatement consécutifs dans le temps, pour lesquels la phase d'attente (113) dure respectivement zéro deuxième, dans lequel les déviations de signaux dues aux phases d'approche ont une direction différente des déviations de signaux dues aux phases de recul,
- surveiller le signal (51 à 54) et identifier l'occurrence d'une séquence de déviations de signaux,
- dès que la séquence a été identifiée: commander l'actionneur (104) de manière à actionner le commutateur (103) par le biais de l'unité d'analyse de signaux (101).

13. Procédé selon la revendication 12, dans lequel un intervalle de temps se situe respectivement entre les déviations de signaux de la séquence, l'intervalle de temps étant situé dans une plage temporelle prédéfinie, dans lequel la plage temporelle prédéfinie est en particulier comprise entre 100 ms et 1 500 ms.

14. Procédé selon l'une des revendications 6 à 13, comportant l'étape consistant à :
- vérifier que les valeurs absolues des déviations de signaux (56, 57) sont supérieures à un niveau prédéfini, si le contrôle est positif, passer à l'étape suivante.

15. Procédé selon l'une des revendications 6 à 14, dans lequel le capteur de geste (1) comporte au moins deux des pixels (21 à 24), comportant l'étape consistant à :
- vérifier que les déviations de signaux analogiques, appartenant les unes aux autres, se situent respectivement dans un deuxième intervalle de temps prédéfini qui est en particulier égal à 50 ms, si le contrôle est positif, passer à l'étape suivante.
